# EUROPEAN PATENT APPLICATION

(11) **EP 3 115 791 A1**
(43) Date of publication of application: **11.01.2017**
(21) Application number: 14884508.4
(22) Date of filing: 21.11.2014
(51) Int. Cl.: G01R 1/067, H01R 13/24

(54) **PROBE PIN AND ELECTRONIC DEVICE USING SAME**

(30) Priority: 06.03.2014 JP 2014044204
(71) Applicant: Omron Corporation, Kyoto-shi, Kyoto 600-8530 (JP)
(72) Inventor: TERANISHI, Hirotada, Kyoto-shi Kyoto 600-8530 (JP); SAKAI, Takahiro, Kyoto-shi Kyoto 600-8530 (JP)
(74) Representative: Kilian Kilian & Partner
(86) International application number: PCT/JP2014/080964
(87) International publication number: WO 2015/133016

(57) **Abstract**

In a probe pin (1) including a coil spring (30), and first and second plungers (10, 20), when the first and second plungers are respectively inserted from both ends of the coil spring (30) toward an inside thereof, the first and second plungers are disposed in a reciprocable manner along an axis center of the coil spring while slide contact surfaces thereof (17, 27) are in slide contact with each other, and the first and second plungers are formed so that the coil spring can be held between a body portion (11) of the first plunger (10) and a body portion (21) of the second plunger (20). The first and second plungers are formed so that the first and second plungers are close to each other and a contact area where the slide contact surface (17) of the first plunger (10) is in contact with the slide contact surface (27) of the second plunger (20) is tilted with respect to the axis center.

## Description

### TECHNICAL FIELD

The present invention relates to a probe pin, for example, a probe pin to be incorporated into an IC test socket.

### BACKGROUND ART

Patent Literature 1 discloses one example of conventional probe pins (see Fig. 6 of Patent Literature 1). This probe pin includes an upper contact pin and a lower contact pin which have the same shape, and a coil spring. The upper contact pin and the lower contact pin are connected to each other inside the coil spring so as to be orthogonal to each other. The upper contact pin has a pair of hooks placed in a groove of the lower contact pin, and the lower contact pin has a pair of hooks placed in a groove of the upper contact pin.

### CITATION LIST

### PATENT LITERATURE

PTL 1: JP 2008-516398 A

### SUMMARY OF INVENTION

### TECHNICAL PROBLEM

However, since the foregoing probe pin in an operated position is restored to its original position only by the spring force of the coil spring. Consequently, when the coil spring is reduced in size, satisfactory spring force cannot be obtained. For this reason, the probe pin cannot be restored to the original position and an operation failure might occur, causing the problem of not being able to reduce the size of the entire probe pin.

In view of the foregoing problem, an object of the present invention is to provide a small-sized probe pin with high reliability.

### SOLUTION TO PROBLEM

A probe pin according to the present invention is characterized by comprising:
a coil spring; and
first and second plungers each provided with a body portion and a sliding piece that extends from the body portion and has a slide contact surface,
the first and second plungers being respectively inserted from both ends of the coil spring toward an inside of the coil spring, and the slide contact surfaces being disposed in a reciprocable manner along an axis center of the coil spring while being in slide contact with each other, and the coil spring being held between the body portion of the first plunger and the body portion of the second plunger,
the first and second plungers being close to each other, and a contact area where the slide contact surface of the first plunger is in contact with the slide contact surface of the second plunger being tilted with respect to the axis center,
when the coil spring is compressed by external force to apply loads of pressing forces in directions of the axis center to the first and second plungers, resultant forces of component forces of the pressing forces in the directions of the axis center, the component forces being generated between the slide contact surfaces by spring forces of the first and second plungers, and the spring force of the coil spring acting in a direction to restore the first and second plungers to original positions of the first and second plungers before the compression of the coil spring.

### ADVANTAGEOUS EFFECTS OF INVENTION

According to the present invention, the first plunger and the second plunger are respectively provided with the siding pieces having the slide contact surfaces that are in slide contact with each other. The first and second plungers are formed such that the contact area of the slide contact surfaces of the sliding pieces is tilted with respect to the axis center when the coil spring is compressed by the external force to apply loads of the pressing forces in the direction of the axis center to the first and second plungers. For this reason, when the loads of the pressing forces in the direction of the axis center are applied to the first and second plungers, the sliding pieces of the first and second plungers are both elastically deformed, and the component forces of the pressing forces in the direction of the axis center, the component forces being generated by the spring forces of the elastically deformed sliding pieces, acts in such the direction to restore the coil spring to the original position before the compression of the coil spring. This allows the use of the coil spring with the spring force smaller by the component forces of the spring forces of the sliding pieces in the direction of the axis center, thereby reducing the size of the coil spring and reducing the size of the entire probe pin.

Hereinafter, a position of each of the first and second plungers before the loads of the pressing forces in the direction of the axis center of the coil spring are applied by the external force to the first and second plungers to compress the coil spring will be referred to as an "original position", and a position of each of the first and second plungers after the loads of the pressing forces in the direction of the axis center of the coil spring are applied by the external force to the first and second plungers to compress the coil spring will be referred to as an "operated position".

Further, according to an embodiment of the present invention, the coil pin may be configured as follows. The sliding pieces of the first and second plungers are curved from the body portions toward free ends of the sliding pieces so as to intersect with the axis center from directions different from each other.

According to the present embodiment, the sliding pieces of the first and second plungers are curved from the body portions toward the free ends of the sliding pieces so as to intersect with the axis center of the coil spring from the directions different from each other. Therefore, when the loads of the pressing forces in the direction of the axis center are applied to the first and second plungers, the sliding pieces of the first and second plungers are both elastically deformed, and the component forces of the pressing forces in the direction of the axis center, the component forces being generated by the spring force of the elastically deformed sliding pieces, acts in the directions to restore the first and second plungers to the original positions. This allows the use of the coil spring with the spring force smaller by the component forces of the spring forces of the sliding pieces in the direction of the axis center, thereby reducing the size of the coil spring and reducing the size of the entire probe pin.

Further, according to an embodiment of the present invention, the probe pin may be configured as follows. The free end of the sliding piece of the first plunger has a Y-shaped cross section, and the sliding piece of the second plunger has a cross section slidable on an inner surface of the free end of the first plunger.

According to the present embodiment, the sliding piece of the second plunger slides on the inner surface of the free end, which has the Y-shaped cross section, of the sliding piece of the first plunger. Therefore, when the loads of the pressing forces in the direction of the axis center are applied to the first and second plungers, the sliding piece of the first plunger is elastically deformed by being pressed by the second plunger, and the component forces of the pressing forces in the direction of the axis center, the component forces being generated by the spring force of the elastically deformed sliding piece, act in the directions to restore the first and second plungers to the original positions. This allows the use of the coil spring with the spring force smaller by the component forces of the spring forces of the sliding pieces in the direction of the axis center, thereby reducing the size of the coil spring and reducing the size of the entire probe pin.

According to an embodiment of the present invention, the probe pin may be configured as follows. The first plunger has a first support projection protruding from the body portion, and a first falling preventive bump protruding from the first plunger at a position apart from the first support projection by a certain distance. The second plunger has a second support projection protruding from the body portion, and a second falling preventive bump protruding from the second plunger at a position apart from the second support projection by a certain distance. One end of the coil spring is held between the first support projection and the first falling preventive bump, and the other end of the coil spring is held between the second support projection and the second falling preventive bump.

According to the present embodiment, the two ends of the coil spring are respectively held between the first and second support projections and the first and second falling preventive bumps. This prevents wobbling of the coil spring and prevents falling of the coil spring.

Further, an electronic device according to the present invention is characterized by including the probe pin.

According to the present invention, it is possible to provide a small-sized probe pin.

### BRIEF DESCRIPTION OF DRAWINGS

Fig. 1 is a perspective view showing an original position of a probe pin according to a first embodiment of the present invention.
Fig. 2 is a front view of the probe pin in Fig. 1.
Fig. 3A is a side view of the probe pin in Fig. 1, and Fig. 3B is a sectional view taken along line III-III in Fig. 3A.
Fig. 4A is a top view showing a state in which the probe pin in Fig. 1 is placed in a housing, and Fig. 4B is a sectional view taken along line IV-IV in Fig. 4A.
Fig. 5 is a perspective view showing an operated position of the probe pin according to the first embodiment of the present invention.
Fig. 6 is a front view of the probe pin in Fig. 5.
Fig. 7A is a side view of the probe pin in Fig. 5, and Fig. 7B is a sectional view taken along line VII-VII in Fig. 7A.
Fig. 8 is a perspective view showing an original position of a probe pin according to a second embodiment of the present invention.
Fig. 9 is a front view of the probe pin in Fig. 8.
Fig. 10A is a side view of the probe pin in Fig. 8, and Fig. 10B is a sectional view taken along line X-X in Fig. 10A.
Fig. 11A is a top view showing a state in which the probe pin in Fig. 1 is placed in a housing, and Fig. 11B is a sectional view taken along line XI-XI in Fig. 11A.
Fig. 12 is a perspective view showing an operated position of the probe pin according to the second embodiment of the present invention;
Fig. 13 is a front view of the probe pin in Fig. 12.
Fig. 14A is a side view of the probe pin in Fig. 12, and Fig. 14B is a sectional view taken along line XIV-XIV in Fig. 14A.

### DESCRIPTION OF EMBODIMENTS

Hereinafter, a probe pin according to the present invention will be described in detail based on embodiments shown in the drawings.

### (First Embodiment)

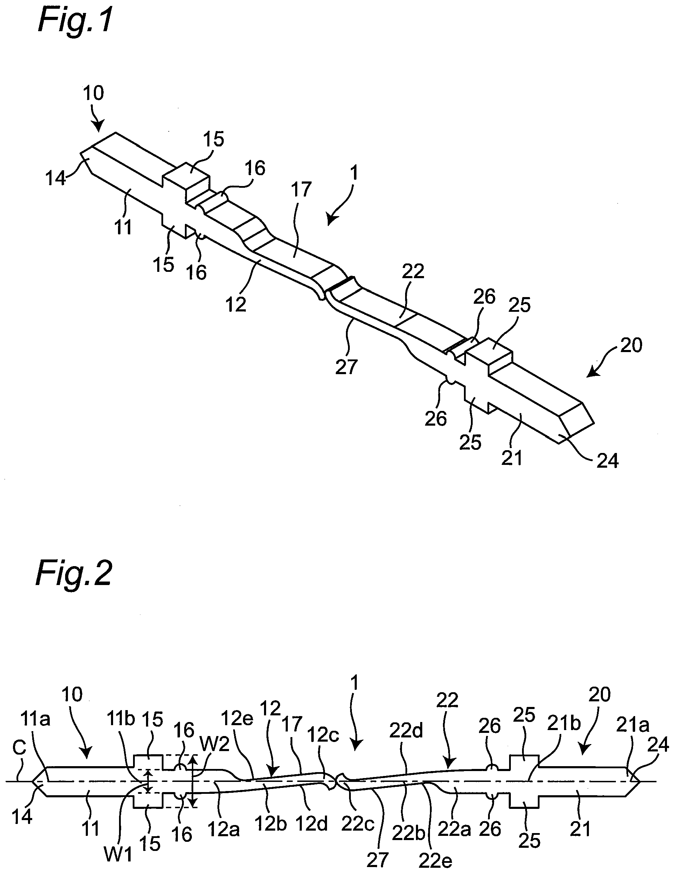

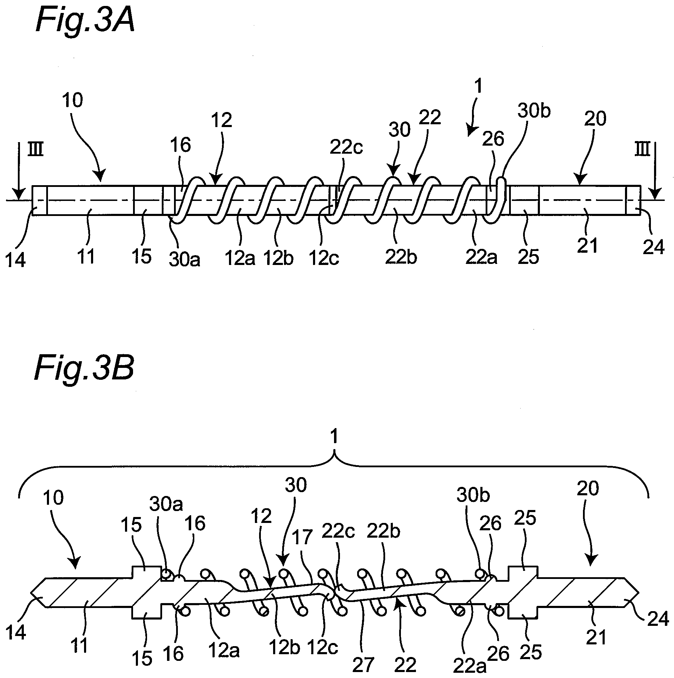

As shown in Figs. 1 to 3B, a probe pin 1 according to a first embodiment of the present invention includes a first plunger 10, a second plunger 20, and a coil spring 30. The first plunger 10 and the second plunger 20 have electrical conductivity and are formed by electroforming, for example. The coil spring 30 is not shown in Figs. 1 and 2 for convenience of the description.

As shown Figs. 1 and 2, the first plunger 10 has a body portion 11 and an elastic sliding piece 12 each having the same width.

The body portion 11 has a substantially rectangular shape in plan view. The body portion 11 has, at one longitudinal end 11a thereof, a tip portion 14 having a triangular shape in plan view. The elastic sliding piece 12 is disposed on the other longitudinal end 11b of the body portion 11 so as to extend from the other end 11b along an axis center C of the coil spring 30. The other longitudinal end 11b of the body portion 11 is also provided with support projections 15, 15 protruding in a short direction.

The elastic sliding piece 12 is made up of a thick portion 12a and a thin portion 12b, and one end of the thick portion 12a is connected to the body portion 11. Further, both side faces of the thick portion 12a are provided with falling preventive bumps 16, 16. A certain clearance is defined between the support projections 15, 15 and the falling preventive bumps 16, 16 of the body portion 11. Further, the thin portion 12b is connected to one portion obtained by dividing the thick portion 12a into two portions in a thickness direction. The thin portion 12b of the elastic sliding piece 12 is curved from a bottom surface 12d to a top surface 12e so as to intersect with the axis center C of the coil spring 30 shown in Fig. 2, and a free end 12c is formed at the tip of the thin portion 12b. The free end 12c is curved from the top surface 12e to the bottom surface 12d of the thin portion 12b.

As shown in Figs. 1 and 2, the second plunger 20 has the same configuration and shape as those of the first plunger 10. That is, the second plunger 20 has a body portion 21 and an elastic sliding piece 22 each having the same width. The body portion 21 has a tip portion 24 at one longitudinal end 21a thereof. The elastic sliding piece 22 is disposed on the other longitudinal end 21b of the body portion 21 so as to extend from the other end 21b in the longitudinal direction. The other longitudinal end 21b of the body portion 21 is also provided with support projections 25, 25 protruding in a short direction.

The elastic sliding piece 22 is made up of a thick portion 22a and a thin portion 22b, and one end of the thick portion 22a is connected to the body portion 21. Further, both side faces of the thick portion 22a are provided with falling preventive bumps 2 6, 26. A certain clearance is defined between the support projections 25, 25 and the falling preventive bumps 26, 26 of the body portion 21. Further, the thin portion 22b is connected to one portion obtained by dividing the thick portion 22a into two portions in a thickness direction. The thin portion 22b of the elastic sliding piece 22 is curved from a bottom surface 22d to a top surface 22e so as to intersect with the axis center C of the coil spring 30, and a free end 22c is formed at the tip of the thin portion 22b. The free end 22c is curved from the top surface 12e to the bottom surface 22d of the thin portion 22b.

In the first plunger 10 and the second plunger 20, slide contact surfaces 17, 27 for ensuring the electric conduction while coming into slide contact with each other are provided on the top surfaces 12e, 22e of the thin portions 12b, 22b of the elastic sliding pieces 12, 22. The slide contact surfaces 17, 27 are surfaces that come into contact with each other when the first plunger 10 and the second plunger 20 slide. In the probe pin 1 according to the first embodiment, the slide contact surfaces 17, 27 cover from the free ends 12c, 22c of the thin portions 12b, 22b to the thick portions 12a, 22a.

Surface treatment such as plating or coating can be performed on the slide contact surfaces 17, 27 or all or part of the first plunger 10 and the second plunger 20 in accordance with the design.

The coil spring 30 is made of carbon steel or stainless steel, for example. As shown in Figs. 3A and 3B, the coil spring 30 has an inner diameter slightly larger than a width W1 of each of the thick portions 12a, 22a of the first and second plungers 10, 20. Further, the coil spring 30 has an outer diameter slightly smaller than a total width W2 of the body portions 11, 21 and the support projections 15, 25 of the first and second plungers 10, 20.

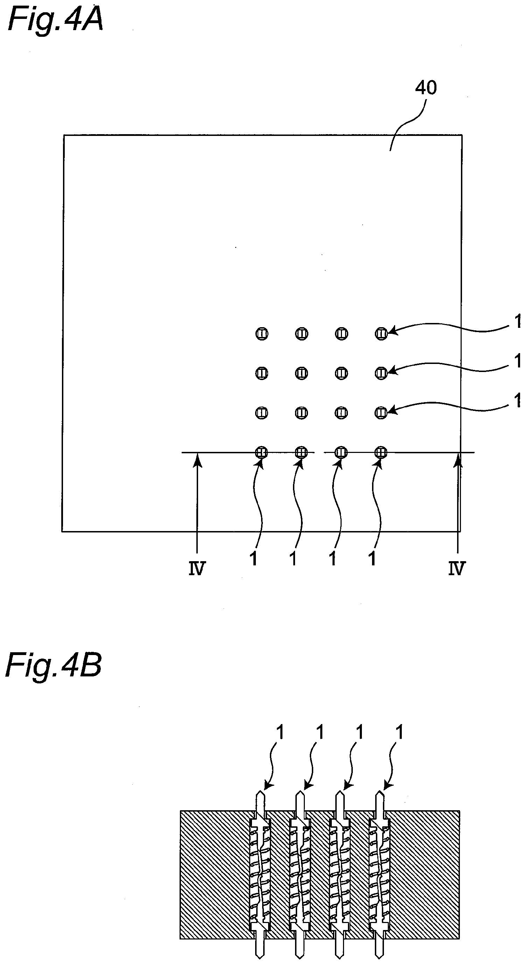

In a state in which the first plunger 10 and the second plunger 20 are both placed in a housing 40 (shown in Figs. 4A and 4B), a spring length of the coil spring 30 is previously adjusted such that force in a compressing direction is applied (i.e., such that the spring force of the coil spring 30 acts in directions to separate the first plunger 10 and the second plunger 20 from each other).

The first plunger 10 and the second plunger 20 are slidably combined as follows.

First, the first plunger 10 and the second plunger 20 are respectively inserted from both ends of the coil spring 30 toward the inside of the coil spring 30. The first plunger 10 and the second plunger 20 are disposed on the axis center C such that the free ends 12c, 22c of the elastic sliding pieces 12, 22 comes face to face.

When the first plunger 10 and the second plunger 20 are inserted from both the sides of the coil spring 30 toward the inside of the coil spring 30, a first end 30a of the coil spring 30 is engaged with and held by the support projections 15, 15 and the falling preventive bumps 16, 16 of the first plunger 10, and a second end 30b of the coil spring 30 is engaged with and held by the support projections 25, 25 and the falling preventive bumps 26, 26 of the second plunger 20.

At this time, the free end 12c of the elastic sliding piece 12 of the first plunger 10 and the free end 22c of the elastic sliding piece 22 of the second plunger 20 are not in contact with each other.

As shown in Figs. 4A and 4B, next, the first plunger 10 and the second plunger 20 are brought close to each other and then are further pressed to the inside of the coil spring 30 until the free end 12c of the elastic sliding piece 12 of the first plunger 10 and the free end 22c of the elastic sliding piece 22 of the second plunger 20 come into press contact with each other. The first plunger 10 and the second plunger 20 are placed into the housing 40 in the state of being pressed inside the coil spring 30.

At this time, the support projection 15 of the first plunger 10 and the support projection 25 of the second plunger 20 are defined in shape so as to come into contact with the inner wall of the housing 40 in the state in which the first plunger 10 and the second plunger 20 are pressed inside the coil spring 30. That is, the displacement of the first and second plungers 10, 20 in a direction orthogonal to the stretching and compressing directions of the coil spring 30 in the housing 40 is regulated by the support projections 15, 25. This enables efficient displacement of the first and second plungers 10, 20 in the direction of the axis center C of the coil spring 30.

Further, since the elastic sliding piece 12 of the first plunger 10 and the elastic sliding piece 22 of the second plunger 20 are curved so as to intersect with the axis center C of the coil spring 30 from different directions, the slide contact surface 17 of the first plunger 10 and the slide contact surface 27 of the second plunger 20 are in contact with each other at the free ends 12c, 22c in the state of being tilted with respect to the axis center C.

Further, in the first plunger 10 and second plunger 20 placed in the housing 40, the free end 12c of the elastic sliding piece 12 of the first plunger 10 and the free end 22c of the elastic sliding piece 22 of the second plunger 20 are constantly in press contact with each other and are constantly brought into conduction with each other. Accordingly, the first plunger 10 and the second plunger 20 can be brought into conduction with each other via the free ends 12c, 22c being a press contact area, and can obtain stable electric contact.

Further, the movement of the coil spring 30 in the stretching direction is restricted by the support projections 15, 25, and the movement of the coil spring 30 in the compressing direction is restricted by the falling preventive bumps 16, 26. This can prevent wobbling of the coil spring 30 and can also prevent falling of the coil spring 30, thus preventing dismantling of the probe pin 1.

Further, providing the support projections 15, 25 allows efficient transmission of the spring force of the coil spring 30 to the first and second plungers 60, 70.

Note that the support projections 15, 25 of the first plunger 10 and the second plunger 20 may have any shape and size which can limit the movement of the coil spring 30 in the stretching direction and can regulate the movement of the first plunger 10 and the second plunger 20 in the direction orthogonal to the stretching and compressing directions of the coil spring 30 in the housing 40, and the shape and outer shape of the support projections 15, 25 can be appropriately selected. Further, the falling preventive bumps 16, 26 may have any shape and size which can limit the movement of the coil spring 30 in the compressing direction of the coil spring 30, and the shape and size thereof can be appropriately selected.

Moreover, the clearances between the support projections 15, 25 and the falling preventive bumps 16, 26 of the first plunger 10 and the second plunger 20 may have any size which can hold the end of the coil spring 30.

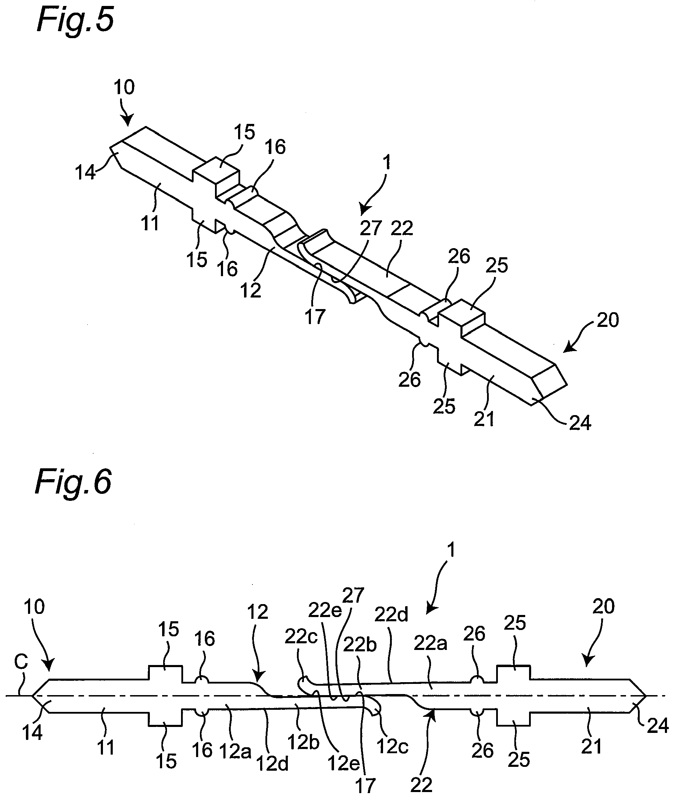

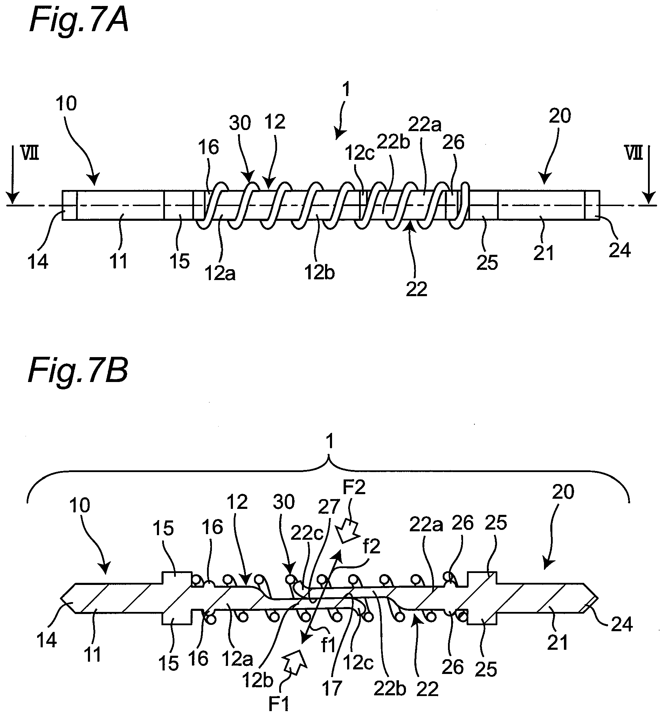

Next, the operation of the probe pin 1 according to the first embodiment will be described using Figs. 5 to 7B. For convenience of the description, the coil spring 30 and the housing 40 are not shown in Figs. 5 and 6, and the housing 40 is not shown in Figs. 7A and 7B.

When the probe pin 1 is to be operated, first, the first plunger 10 and the second plunger 20 of the probe pin 1 in the original position are pressed from the tip portions 14, 24 to the inside of the coil spring 30. Note that the first and second plungers 10, 20 reciprocate along the axis center C of the coil spring 30 and are brought into conduction with each other via the slide contact surfaces 17, 27.

When the first plunger 10 and the second plunger 20 are pressed to the inside of the coil spring 30, the thin portions 12b, 22b of the elastic sliding pieces 12, 22 are gradually elastically deformed outward (the first plunger 10 is deformed downward and the second plunger 20 is deformed upward in Fig. 6) because of the curved shapes of the free ends 12c, 22c.

When the first plunger 10 and the second plunger 20 are further pressed inward, as shown in Figs. 5 and 6, the thin portion 22b of the elastic sliding piece 22 of the second plunger 20 is pressed in a sliding state into a space where the free end 12c of the elastic sliding piece 12 of the first plunger 10 is pushed out, and the thin portion 12b of the elastic sliding piece 12 of the first plunger 10 is pressed in a sliding state into a space where the free end 22c of the elastic sliding piece 22 of the second plunger 20 is pushed out. That is, a state is ensured, in which the slide contact surface 17 of the first plunger 10 and the slide contact surface 27 of the second plunger 20 are brought into conduction with each other while being in slide contact with each other.

At this time, the thin portions 12b, 22b are located in parallel with each other, and the facing top surfaces 12e, 22e are in press contact with each other. That is, the first plunger 10 is constantly pressed by spring force of the elastic sliding piece 22 of the second plunger 20, and the second plunger 20 is constantly pressed by spring force of the elastic sliding piece 12 of the first plunger 10.

In the probe pin 1 in the operated position, since the first plunger 10 and the second plunger 20 press each other by the spring forces of the elastic sliding pieces 12, 22 via the slide contact surfaces 17, 27 of the thin portions 12b, 22b, the first plunger 10 and the second plunger 20 are constantly in press contact with each other and are constantly brought into conduction with each other. Accordingly, the first plunger 10 and the second plunger 20 can be brought into conduction with each other via the slide contact surfaces 17, 27 of the thin portions 12b, 22b which are a press contact area, and can obtain stable electric contact.

Meanwhile, as shown in Figs. 7A and 7B, resultant forces F1, F2 of the spring forces of the elastic sliding pieces 12, 22 of the first and second plungers 10, 20 act in the directions of the free ends 12c, 22c of the elastic sliding pieces 12, 22 and the direction of the axis center C of the first and second plungers 10, 20 (the resultant force F1 of the spring force of the first plunger 10 acts in an obliquely upper right direction, and the resultant force F2 of the spring force of the second plunger 20 acts in an obliquely lower left direction). That is, the resultant forces F1, F2 of the spring forces of the elastic sliding pieces 12, 22 of the first and second plungers 10, 20, which are forces in the oblique directions with respect to the axis center C of the coil spring 30, are applied to the slide contact surfaces 17, 27 of the first and second plungers 10, 20. As a result, component forces in the direction of the axis center C of the pressing forces generated between the slide contact surfaces 17, 27 by the spring forces of the first and second plungers 10, 20 (i.e., component forces in the direction of the axis center C of the resultant forces F1, F2 of the spring forces of the elastic sliding pieces 12, 22 of the first and second plungers 10, 20 and component forces in the direction of the axis center C of reaction forces f1, f2 against the resultant forces F1, F2 of the spring forces of the elastic sliding pieces 12, 22) act in directions to restore the first and second plungers 10, 20 to the original positions.

Therefore, when the probe pin 1 is restored from the operated position to the original position, the first and second plungers 10, 20 are applied not only with a load based on the spring force of the coil spring 30, but also a load based on the resultant forces F1, F2 of the spring forces of the elastic sliding pieces 12, 22 and reaction forces f1, f2 of the resultant forces F1, F2. It is thereby possible to use the coil spring 30 with smaller spring force than spring force required for restoring the first and second plungers 10, 20 to the original positions, and to reduce the size of the probe pin 1.

Since the free ends 12c, 22c of the elastic sliding pieces 12, 22 of the first plunger 10 and the second plunger 20 are pushed outward while being pressed each other and reciprocate in the sliding state, impurities and the like generated on the surfaces of the slide contact surfaces 17, 27 are rubbed off, and the wiping effect can thus be obtained.

Moreover, the first plunger 10 and the second plunger 20 can slide and move until the free end 12c of the elastic sliding piece 12 of the first plunger 10 (second plunger 20) comes into contact with the thick portion 22a of the elastic sliding piece 22 of the second plunger 20 (first plunger 10) and until the free end 22c of the elastic sliding piece 22 of the second plunger 20 comes into contact with the thick portion 12a of the elastic sliding piece 12 of the first plunger 10.

In the probe pin 1 according to the first embodiment, the thicknesses of the body portion 11 and elastic sliding piece 12 of the first plunger 10 and the thicknesses of the body portion 21 and elastic sliding piece 22 of the second plunger 20 are made the same, but this is not restrictive. The thicknesses of the body portion 11 and elastic sliding piece 12 of the first plunger 10 may be made different from the thicknesses of the body portion 21 and elastic sliding piece 22 of the second plunger 20.

### (Second Embodiment)

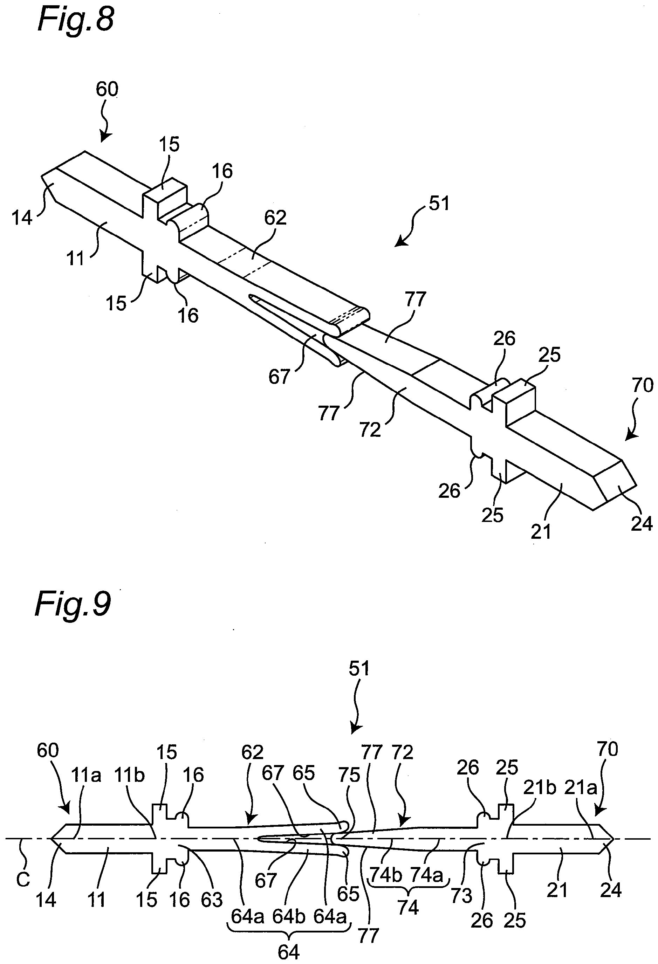

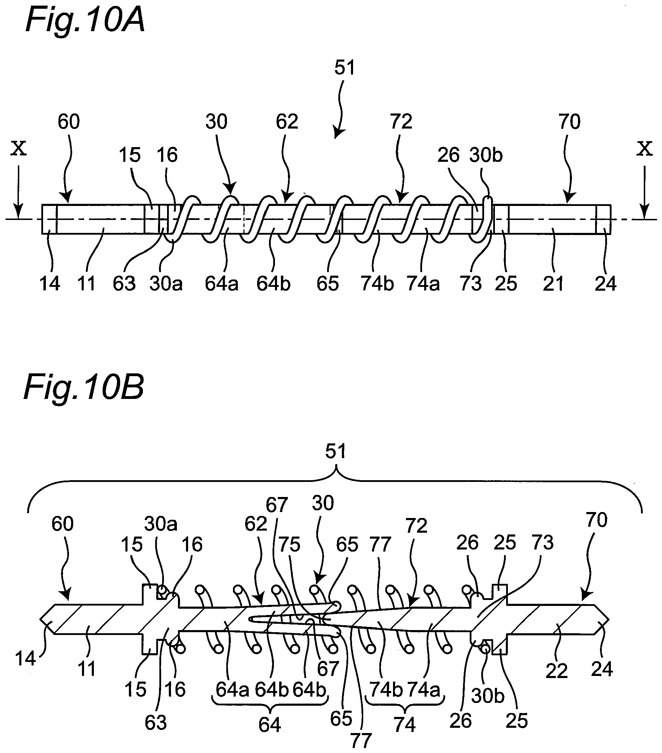

As shown in Figs. 8 to 10B, a probe pin 51 according to a second embodiment of the present invention includes a first plunger 60, a second plunger 70, and a coil spring 30. The first plunger 60 and the second plunger 70 have electrical conductivity and are formed by electroforming, for example. Note that identical portions with those in the first embodiment are denoted with identical reference signs, and the description thereof will not be given. A difference of the second embodiment from the first embodiment will be described.

As shown Figs. 8 and 9, the first plunger 60 is provided with a body portion 11 and an elastic sliding piece 62 having a Y shape in cross section. Further, the first plunger 60 has the same width and is formed to be line-symmetrical with respect to an axis center C of the coil spring 30 shown in Fig. 9. The coil spring 30 is not shown in Figs. 8 and 9 for convenience of the description.

The elastic sliding piece 62 is made up of a base portion 63 and an elastic sliding portion 64 and has the Y shape in cross section. The elastic sliding piece 62 has an end on the base portion 63 side connected to the other longitudinal end 11b of the body portion 11, and extends along the axis center C of the coil spring 30. Both side faces of the base portion 63 are provided with falling preventive bumps 16, 16. A certain clearance is defined between support projections 15, 15 and the falling preventive bumps 16, 16 of the body portion 11. Further, the elastic sliding portion 64 is made up of a plate-like portion 64a continued to the base portion 63, and a pair of elastic pieces 64b, 64b extending from the plate-like portion 64a in the longitudinal direction. The pair of elastic pieces 64b, 64b have free ends 65, 65 at the tips thereof. The free ends 65, 65 are curved in a direction away from the axis center C.

As shown Figs. 8 and 9, the second plunger 70 includes a body portion 21 and a sliding piece 72. Further, the second plunger 70 has the same width, and is formed to be line-symmetrical with respect to the axis center C.

The sliding piece 72 is made up of a base portion 73 and a sliding piece body 74, has an end on the base portion 73 side connected to the other longitudinal end 21b of the body portion 21, and extends along the axis center C of the coil spring 30. Both side faces of the base portion 73 are provided with falling preventive bumps 26, 26. A certain clearance is defined between support projections 25, 25 and the falling preventive bumps 26, 26 of the body portion 21. The sliding piece body 74 is made up of a plate-like portion 74a having a fixed thickness and continued to the base portion 73, and a tapered portion 74b extending from the plate-like portion 74a in the longitudinal direction. The tapered portion 74b has a free end 75 having a curved shape at the tip thereof, and is formed so as to be gradually tapered toward the free end 75.

Note that the free end 75 of the sliding piece 72 of the second plunger 70 is formed so as to have a thickness which is substantially the same as a size of a clearance between the free ends 65, 65 of the elastic pieces 64b, 64b of the elastic sliding portion 64 of the elastic sliding piece 62 of the first plunger 60 in a natural state.

Further, similarly to the first embodiment, the first plunger 60 and the second plunger 70 of the second embodiment are provided with slide contact surfaces 67, 77 for ensuring the conduction while coming into slide contact with each other. The slide contact surface 67 of the first plunger 60 is provided on each of the facing side surfaces of the pair of elastic pieces 64b, 64b of the elastic sliding portion 64 of the elastic sliding piece 62. The slide contact surface 77 of the second plunger 70 is provided on each of the tilted side surface of the tapered portion 74b of the sliding piece 72. The slide contact surfaces 67, 77 are surfaces that come into contact with each other when the first plunger 60 and the second plunger 70 slide. In the probe pin 51 according to the second embodiment, the first plunger 60 and the second plunger 70 come into contact with each other in two places. For this reason, the first and second plungers 60, 70 are each provided with two slide contact surfaces 67, 77.

Surface treatment such as plating or coating can be performed on the slide contact surfaces 67, 77 or all or part of the first plunger 60 and the second plunger 70 in accordance with the design.

The first plunger 10 and the second plunger 20 are slidably combined as follows.

First, the first plunger 60 and the second plunger 70 are respectively inserted from both ends of the coil spring 30 toward the inside of the coil spring 30. The first plunger 60 and the second plunger 70 are disposed such that the free ends 65, 65 of the elastic sliding piece 62 of the first plunger 60 and the free end 75 of the sliding piece 72 of the second plunger 70 come face to face.

When the first plunger 60 and the second plunger 70 are inserted into the coil spring 30, the first end 30a of the coil spring 30 is engaged with and held by the support projections 15, 15 and the falling preventive bumps 16, 16 of the first plunger 60, and the second end 30b of the coil spring 30 is engaged with and held by the support projections 25, 25 and the falling preventive bumps 26, 26 of the second plunger 70.

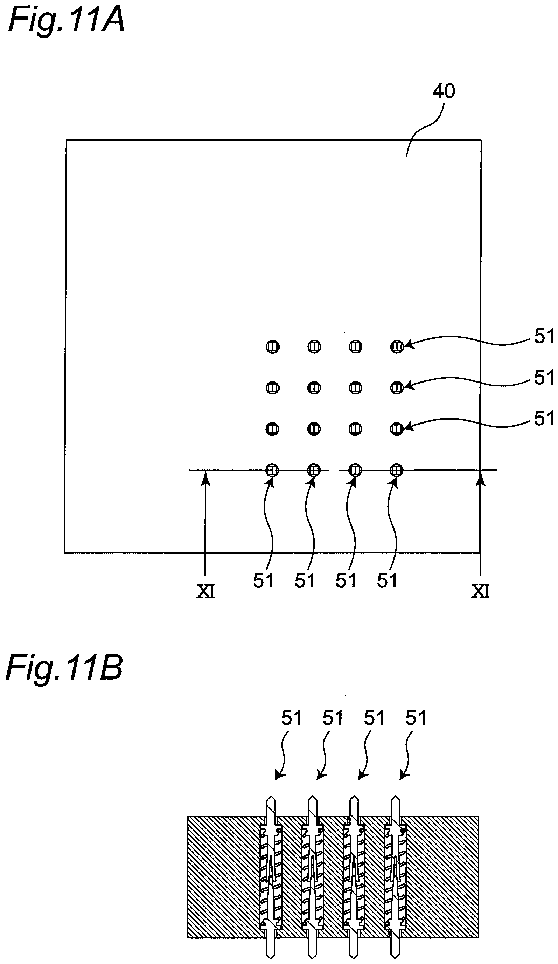

As shown in Figs. 11A and 11B, next, the first plunger 60 and the second plunger 70 are further pressed to the inside of the coil spring 30 until the free ends 65, 65 of the elastic sliding piece 62 of the first plunger 60 and the free end 75 of the sliding piece 72 of the second plunger 70 come into contact with each other (i.e., they come into the state shown in Figs. 8 to 10B). Then, the first plunger 60 and second plunger 70 pressed inside the coil spring 30 are placed into the housing 40.

At this time, the support projection 15 of the first plunger 60 and the support projection 25 of the second plunger 70 are defined in shape so as to come into contact with the inner wall of the housing 40 in the state in which the first plunger 60 and the second plunger 70 are pressed into the coil spring 30. That is, the displacement of the first and second plungers 60, 70 in the direction orthogonal to the stretching and compressing directions of the coil spring 30 in the housing 40 can be regulated by the support projections 15, 25. This enables efficient displacement of the first and second plungers 60, 70 in the direction of the axis center C of the coil spring 30.

Further, the elastic pieces 64b, 64b of the elastic sliding portion 64 of the elastic sliding piece 62 of the first plunger 60 come into the state of sandwiching the tapered portion 74b of the sliding piece body 74 of the sliding piece 72 of the second plunger 70. That is, the slide contact surface 67 of the first plunger 60 and the slide contact surface 77 of the second plunger 70 are constantly in press contact with each other and are constantly brought into conduction with each other, and are tilted with respect to the axis center C of the coil spring 30. Accordingly, the first plunger 60 and the second plunger 70 can be brought into conduction with each other via the inner surfaces of the free ends 65, 65 of the elastic sliding piece 62 and the free end 75 of the sliding piece 72 which are the press contact area, and can obtain stable electric contact.

Further, the movement of the coil spring 30 in the stretching direction is restricted by the support projections 15, 25, and the movement of the coil spring 30 in the compressing direction is restricted by the falling preventive bumps 16, 26. This can prevent wobbling of the coil spring 30 and can also prevent falling of the coil spring 30, thus preventing dismantling of the probe pin 51.

Further, providing the support projections 15, 25 allows efficient transmission of the spring force of the coil spring 30 to the first and second plungers 60, 70.

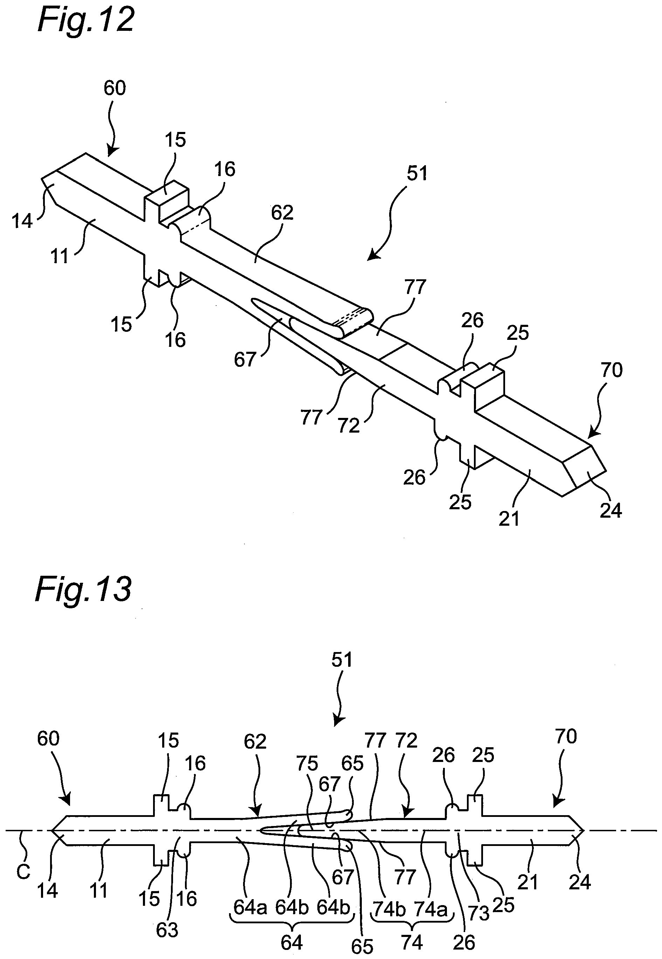

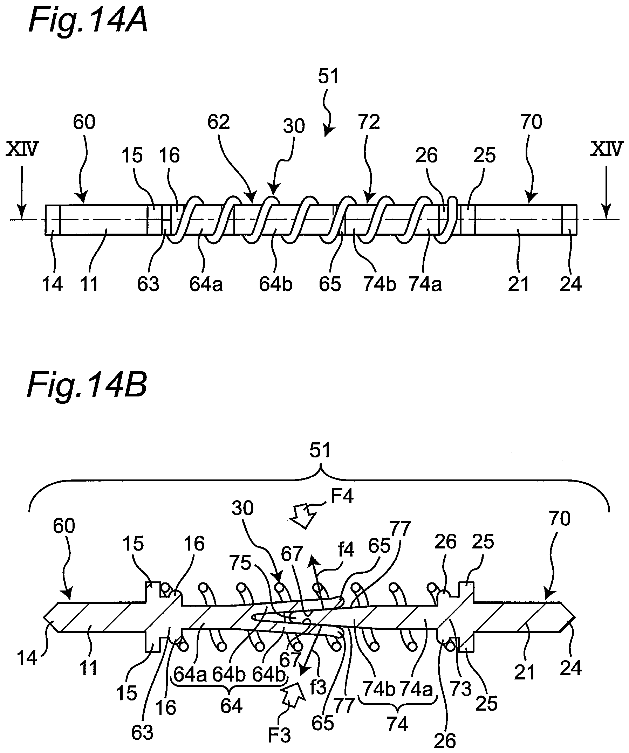

Next, the operation of the probe pin 51 according to the second embodiment will be described using Figs. 12 to 14B. For convenience of the description, the coil spring 30 and the housing 40 are not shown in Figs. 12 and 13, and the housing 40 is not shown in Figs. 14A and 14B.

When the probe pin 51 is to be operated, first, the first plunger 60 and the second plunger 70 of the probe pin 51 in the original position are pressed from the tip portions 14, 24 to the inside of the coil spring 30. Note that the first and second plungers 60, 70 reciprocate along the axis center C of the coil spring 30 and are brought into conduction with each other while being in slide contact with each other via the slide contact surfaces 67, 77.

When the first plunger 60 and the second plunger 70 are pressed to the inside of the coil spring 30, the free end 75 of the sliding piece 72 of the second plunger 70 is pressed into the clearance between the elastic pieces 64b, 64b of the elastic sliding portion 64 of the elastic sliding piece 62 of the first plunger 60 in the state of sliding on the inner surfaces of the elastic pieces 64b, 64b. Hence the clearance between the elastic pieces 64b, 64b of the elastic sliding portion 64 of the first plunger 60 is gradually enlarged by the free end 75 of the sliding piece 72 of the second plunger 70, and the elastic pieces 64b, 64b of the elastic sliding portion 64 of the first plunger 60 are elastically deformed outward (in a vertical direction in Fig. 12).

At this time, since the sliding piece 72 of the second plunger 70 is constantly pressed by the spring forces of the elastic pieces 64b, 64b of the elastic sliding portion 64 of the elastic sliding piece 62 of the first plunger 60 via the inner surfaces of the elastic pieces 64b, 64b, the first plunger 60 and the second plunger 70 are constantly in press contact with each other and are constantly brought into conduction with each other via the slide contact surfaces 67, 77. Accordingly, the first plunger 60 and the second plunger 70 can be brought into conduction with each other via the inner surfaces of the elastic pieces 64b, 64b which are the press contact area, and can obtain stable electric contact.

Meanwhile, as shown in Figs. 14A and 14B, resultant forces F3, F4 of the spring forces of the elastic pieces 64b, 64b of the elastic sliding piece 62 of the first plunger 60 act in the direction of the free end 65 of the elastic sliding piece 62 and the direction of the axis center C (the resultant force F3 of the spring force of the upper elastic piece 64b acts in an obliquely lower right direction, and the resultant force F4 of the spring force of the lower elastic piece 64b acts in an obliquely upper right direction in Figs. 14A and 14B). That is, the resultant forces F3, F4 of the spring forces of the elastic pieces 64b, 64b of the elastic sliding piece 62, which are forces in the oblique directions with respect to the axis center C of the coil spring 30, are applied to the slide contact surfaces 67, 77 of the first plunger 60 and the second plunger 70. As a result, component forces in the direction of the axis center C of the pressing forces generated between the slide contact surfaces 67, 77 by the spring forces of the first and second plungers 60, 70 (i. e. , component forces in the direction of the axis center C of the spring forces of the elastic pieces 64b, 64b of the first plunger 60 and component forces in the direction of the axis center C of reaction forces against the resultant forces F3, F4 of the spring forces of the elastic pieces 64b, 64b) act in the directions to restore the first and second plungers 60, 70 to the original positions.

Therefore, when the probe pin 1 is to be restored from the operated position to the original position, not only a load based on the spring force of the coil spring 30, but also the component forces in the axis center direction of the spring forces of the elastic pieces 64b, 64b of the first plunger 60 and the component forces in the axis center direction of the reflective forces f3, f4 act on the first and second plungers 60, 70. It is thereby possible to use the coil spring 30 with smaller spring force than spring force required for restoring the first and second plungers 60, 70 to the original positions, and to reduce the size of the probe pin 51.

Since the free end 75 of the sliding piece 72 of the second plunger 70 reciprocates in a sliding state while being pressed by the spring forces of the elastic pieces 64b, 64b of the elastic sliding portion 64 of the first plunger 60, impurities and the like generated on the surfaces of the slide contact surface 67 of the first plunger 60 and the slide contact surface 77 of the second plunger 70 are rubbed off, and the wiping effect can thus be obtained.

Further, slidably movable ranges of the first plunger 60 and second plunger 70 can be appropriately changed by adjusting the lengths of the elastic pieces 64b, 64b of the elastic sliding portion 64 of the first plunger 60 and the length of the sliding piece 72 of the second plunger 70. Note that the slidably movable ranges of the first plunger 60 and second plunger 70 can also be changed by adjusting a tapered angle of the tapered portion 74b of the sliding piece body 74 of the sliding piece 72 of the second plunger 70.

In the probe pin 51 according to the second embodiment, the free ends 65, 65 of the elastic sliding piece 62 of the first plunger 60 and the free end 75 of the sliding piece 72 of the second plunger 70 are curved, but this is not restrictive. For example, each of these free ends may be formed into a polygonal shape such as a triangular shape or a square shape.

In the probe pin 51 according to the second embodiment, the thicknesses of the body portion 11 and elastic sliding piece 62 of the first plunger 60 and the thicknesses of the body portion 21 and sliding piece 72 of the second plunger 70 are made the same, but this is not restrictive. The thicknesses of the body portion 11 and elastic sliding piece 62 of the first plunger 60 may be made different from the thicknesses of the body portion 21 and sliding piece 72 of the second plunger 70.

Further, in the probe pin 51 according to the second embodiment, the clearance between the free ends 65, 65 of the first plunger 60 in the natural state is formed in size being the same as the thickness of the free end 75 of the sliding piece 72 of the second plunger 70, but this is not restrictive. For example, by making the clearance between the free ends 65, 65 of the first plunger 60 smaller than the thickness of the free end 75 of the sliding piece 72 of the second plunger 70, the press contact of the elastic pieces 64b, 64b of the first plunger 60 on the sliding piece 72 of the second plunger 70 can be enhanced.

In the probe pins 1, 51 according to the first and second embodiments, the first plungers 10, 60 and the second plungers 20, 70 are formed by electroforming, but this is not restrictive. It is possible to arbitrarily select any method so long as it allows formation of the first plungers 10, 60 and the second plungers 20, 70 according to the first and second embodiments.

The coil spring 30 is provided in the probe pins 1, 51 according to the first and second embodiments, but this is not restrictive. In the first embodiment, the probe pin 1 may be restored from the operated position to the original position only by the spring force of the elastic sliding piece 12 of the first plunger 10 and the spring force of the elastic sliding piece 22 of the second plunger 20. Further, in the second embodiment, the probe pin 51 can be restored from the operated position to the original position only by the spring forces of the elastic pieces 64b, 64b of the elastic sliding portion 64 of the elastic sliding piece 62 of the first plunger 60. Note that in this case, it is necessary to cover the first plungers 10, 60 and the second plungers 20, 70 with a housing or the like in place of the coil spring 30 so as to prevent dismantling of the probe pins 1, 51.

Moreover, in the probe pins 1, 51 according to the first and second embodiments, the spring length of the coil spring 30 is previously adjusted such that the force in the compressing direction is applied in the state in which the first plungers 10, 60 and the second plungers 20, 70 are both placed inside the housing 40, but this is not restrictive. For example, the spring length of the coil spring 30 may be adjusted by making the first plungers 10, 60 and the second plungers 20, 70 before being placed into the housing 40 into contact with the housing 40 come into contact with each other so that they are not applied with force in the state of being placed in the housing 40.

It is natural that the respective constituents of the probe pins 1, 51 according to the first and second embodiments may be exchanged or added if possible.

The probe pins 1, 51 according to the first and second embodiments can be applied to an electronic device such as an IC test socket.

### INDUSTRIAL APPLICABILITY

The probe pin according to the present invention is not restricted to the first and second embodiments and is not particularly limited so long as being a probe pin having a slide contact surface that tilts with respect to an axis center of a coil spring and can be reduced in size.

### REFERENCE SIGNS LIST

- 1, 51.: probe pin
- 10, 60.: first plunger
- 20, 70.: second plunger
- 30.: coil spring
- 40.: housing
- 11, 21.: body portion
- 12, 22, 62.: elastic sliding piece
- 12a, 22a.: thick portion
- 12b, 22b.: thin portion
- 12c, 22c.: free end
- 12d, 22d.: bottom surface
- 12e, 22e.: top surface
- 14, 24.: tip portion
- 15, 25.: support projection
- 16, 26.: falling preventive bump
- 17, 27, 67, 77.: slide contact surface
- 63, 73.: base portion
- 64.: elastic sliding portion
- 64a.: plate-like portion
- 64b.: elastic piece
- 65, 75.: free end
- 72.: sliding piece
- 74.: sliding piece body
- 74a.: plate-like portion
- 74b.: tapered portion

## Claims

1. A probe pin **characterized by** comprising:
a coil spring; and
first and second plungers each provided with a body portion and a sliding piece that extends from the body portion and has a slide contact surface,
the first and second plungers being respectively inserted from both ends of the coil spring toward an inside of the coil spring, and the slide contact surfaces being disposed in a reciprocable manner along an axis center of the coil spring while being in slide contact with each other, and the coil spring being held between the body portion of the first plunger and the body portion of the second plunger,
the first and second plungers being close to each other, and a contact area where the slide contact surface of the first plunger is in contact with the slide contact surface of the second plunger being tilted with respect to the axis center,
when the coil spring is compressed by external force to apply loads of pressing forces in directions of the axis center to the first and second plungers, resultant forces of component forces of the pressing forces in the directions of the axis center, the component forces being generated between the slide contact surfaces by spring forces of the first and second plungers, and the spring force of the coil spring acting in a direction to restore the first and second plungers to original positions of the first and second plungers before the compression of the coil spring.

2. The probe pin according to claim 1, **characterized in that**
the sliding pieces of the first and second plungers are curved from the body portions toward free ends of the sliding pieces so as to intersect with the axis center from directions different from each other.

3. The probe pin according to claim 1, **characterized in that**
a free end of the sliding piece of the first plunger has a Y-shaped cross section, and the sliding piece of the second plunger has a cross section slidable on an inner surface of the free end of the first plunger.

4. The probe pin according to any one of claims 1-3, **characterized in that**
the first plunger having a first support projection protruding from the body portion, and a first falling preventive bump protruding from the first plunger at a position apart from the first support projection by a certain distance,
the second plunger having a second support projection protruding from the body portion, and a second falling preventive bump protruding from the second plunger at a position apart from the second support projection by a certain distance,
a first end of the coil spring being held between the first support projection and the first falling preventive bump, and a second end of the coil spring being held between the second support projection and the second falling preventive bump.

5. An electronic device using the probe pin according to any one of claims 1-4.
